# EUROPÄISCHE PATENTANMELDUNG

(11) **EP 0 678 915 A2**
(43) Veröffentlichungstag der Anmeldung: **25.10.1995**
(21) Anmeldenummer: 95200881.1
(22) Anmeldetag: 07.04.1995
(51) Int. Cl.: H01L 21/8247, H01L 27/115

(54) **Integrierte Schaltungsanordnung mit einem EEPROM, Halbleiterscheibe mit solchen integrierten Schaltungen sowie Verfahren zur Verwendung einer solchen Halbleiterscheibe**

(30) Priorität: 16.04.1994 DE 4413257
(71) Anmelder: Philips Patentverwaltung GmbH, 22335 Hamburg (DE); Philips Electronics N.V., 5621 BA Eindhoven (NL)
(72) Erfinder: Armbrust, Dirk, c/o Philips Patentverwaltung GmbH, D-20097 Hamburg (DE); Timm, Volker, Dr., c/o Philips Patentverwaltung, D-20097 Hamburg (DE); Holtz, Tom., c/o Philips Patentverwaltung GmbH, D-20097 Hamburg (DE)
(74) Vertreter: Peters, Carl Heinrich, Dipl.-Ing.

(57) **Zusammenfassung**

Integrierte Schaltungen mit einem EEPROM erfordern einen großen Zeitaufwand für die Prüfung, da die Schreibzeit für eine Speicherzelle sehr lang ist. Insbesondere der erste Test nach der Herstellung auf dem Wafer ist zeitaufwendig. Erfindungsgemäß wird nun vorgeschlagen, den ersten Test nach der Herstellung drastisch abzukürzen, indem eine Anzahl integrierter Schaltungen parallel mit Spannung versorgt wird, und jede integrierte Schaltung enthält einen Schaltungsteil, durch den mehrere blockweise Schreibzyklen für abwechselnd "0" und "1" weitgehend autonom durchgeführt werden, wobei am Ende des ersten Testschritts eine vorgegebene Information erhalten bleibt. Danach erfolgt eine Wärmebehandlung, und dann erst werden die integrierten Schaltungen einzeln kontaktiert und zunächst auf Informationserhaltung geprüft. Für die parallele Versorgung der Anzahl von integrierten Schaltungen mit Betriebsspannung im ersten Testschritt werden Versorgungsanschlüsse der integrierten Schaltungen dieser Anzahl über die Trennbahnen auf dem Wafer hinweg miteinander verbunden und eine der integrierten Schaltungen kontaktiert. Beim Trennen der einzelnen integrierten Schaltungen werden diese Leiterbahnen dann automatisch aufgetrennt.

## Beschreibung

Die Erfindung betrifft eine integrierte Schaltungsanordnung mit einem EEPROM sowie mit einer Steuerschaltung zum Steuern des Lesens und Schreibens von Information im EEPROM und mit Spannungsanschlüssen zum Zuführen einer Versorgungsspannung. Ferner betrifft die Erfindung eine Halbleiterscheibe mit einer Mehrzahl von darauf erzeugten integrierten Schaltungen, die in Reihen und/oder Spalten mit dazwischen liegenden Bahnen für Trennschnitte zum Trennen der integrierten Schaltungen voneinander auf der Halbleiterscheibe angeordnet sind und von denen jede integrierte Schaltung Spannungsanschlüsse aufweist, sowie ein Verfahren zur Prüfung der Funktionsfähigkeit aller integrierten Schaltungen auf der Halbleiterscheibe, wobei nach der vollständigen Herstellung die integrierten Schaltungen an eine Spannung angeschlossen werden zum Durchführen eines ersten Prüfschritts, nach dessen Abschluß alle Speicherplätze die gleiche vorgegebene Information enthalten, danach die Halbleiterscheibe im spannungslosen Zustand einer Wärmebehandlung unterzogen wird und anschließend die integrierten Schaltungen erneut an eine Spannung angeschlossen werden zum Durchführen eines zweiten Prüfschritts, in dem der Inhalt der Speicherplätze ausgelesen und geprüft wird.

Integrierte Schaltungen mit einem EEPROM und einer Steuerschaltung darauf sind allgemein bekannt. Solche integrierten Schaltungen sind beispielsweise in der sogenannten Telefonkarte enthalten, mit der die Benutzung entsprechend ausgerüsteter öffentlicher Fernsprecher möglich ist. Weitere Anwendungen solcher integrierten Schaltungen finden sich beispielsweise in Kreditkarten zur Durchführung von Geldtransaktionen. Ferner können solche integrierten Schaltungen auch als Steuerschaltung einen Microprozessor aufweisen, bei dem der EEPROM einen Teil des gesamten Speichers des Microprozessors darstellt.

Integrierte Schaltungen müssen stets nach ihrer Herstellung auf ihre Funktionsfähigkeit geprüft werden, bevor sie weiterverarbeitet werden. Dazu gehört auch die Prüfung der in der integrierten Schaltung enthaltenen Speicher, insbesondere daraufhin, ob alle Speicherzellen ordnungsgemäß adressiert und gelesen und gegebenenfalls beschrieben werden können. Bei integrierten Schaltungen, die einen EEPROM enthalten, tritt dabei die Schwierigkeit auf, daß das Einschreiben von Informationen in solche Speicher erhebliche Zeit in Anspruch nimmt. Dadurch ist die Prüfung von solchen integrierten Schaltungen sehr zeitaufwendig. Hinzu kommt, daß zur Prüfung, ob die Speicherzellen in einem EEPROM ihre Information dauerhaft behalten, die erste Prüfung in zwei Prüfschritten mit einer dazwischen eingefügten Wärmebehandlung durchgeführt wird. Das bedeutet, daß jede integrierte Schaltung zweimal vollständig mit allen Anschlüssen kontaktiert und mit einem Testgerät verbunden werden muß.

Aufgabe der Erfindung ist es, eine integrierte Schaltung der eingangs genannten Art mit einem EEPROM anzugeben, die einfacher und mit weniger Zeitaufwand geprüft werden kann.

Diese Aufgabe wird erfindungsgemäß dadurch gelöst, daß die Steuerschaltung eine Prüfschaltung aufweist, die beim erstmaligen Zuführen von Spannung an wenigstens einige Spannungsanschlüsse weitgehend selbsttätig in alle Speicherzellen des EEPROM vorzugsweise eine Anzahl Male abwechselnd die binäre Information "0" und "1" einschreibt.

Eine solche Prüfschaltung kann einfach aufgebaut sein und im wesentlichen eine einfache Ablaufsteuerung enthalten, die dem Speicher abwechselnd die Information "1" und "0" zuführt und diese Information vorzugsweise parallel in alle Speicherzellen des EEPROM einschreibt, indem der Adreßdecoder auf parallele Ansteuerung der Spalten- und Zeilenleitungen eingestellt wird. Die Ablaufsteuerung kann völlig selbständig arbeiten, beispielsweise mit Hilfe eines Zählers und eines Oszillators, der üblicherweise in der Steuerschaltung für den Normalbetrieb vorhanden ist, oder über einen von außen zugeführten Steuertakt.

Die Aktivierung der Prüfschaltung und damit des ersten Prüfschritts kann auf verschiedene Weise erfolgen. Eine Möglichkeit besteht darin, über einen weiteren Anschluß ein Steuersignal, insbesondere den Steuertakt, zuzuführen und damit das Einschreiben der Informationen zu steuern. Eine weitere Möglichkeit besteht darin, daß ein zusätzlicher Spannungsanschluß vorgesehen wird, wobei die Prüfschaltung automatisch aktiviert wird, wenn eine Versorgungsspannung über diesen zusätzlichen Spannungsanschluß zugeführt wird.

Dadurch braucht die integrierte Schaltung nur mit der Versorgungsspannung verbunden zu werden, um den ersten Prüfschritt durchzuführen. Dies bedeutet, daß dieser erste Prüfschritt für eine Vielzahl von integrierten Schaltungen gleichzeitig parallel durchgeführt werden kann, indem diese integrierten Schaltungen durch entsprechende Kontaktierungselemente gleichzeitig mit einer Spannungsquelle verbunden werden, und für diesen ersten Prüfschritt ist auch keine komplizierte Prüfanordnung erforderlich.

Häufig sind die integrierten Schaltungen bzw. die damit versehenen Karten für Anwendungsfälle vorgesehen, bei denen eine Veränderung des Speicherinhalts außerhalb der normalen Anwendung unbedingt verhindert werden muß. Beispielsweise muß bei Telefonkarten verhindert werden, daß der Speicherinhalt gelöscht und damit die Karte unzulässig erneut verwendbar gemacht werden kann. Aus diesem Grunde ist eine Ausgestaltung der Erfindung dadurch gekennzeichnet, daß die Prüfschaltung für die gesamte Lebensdauer der integrierten Schaltung dauerhaft abschaltbar ist. Wenn nämlich einmal nach Herstellung der integrierten Schaltung eine Prüfung in der angegebenen Weise erfolgt ist, wird eine solche Prüfung während der Verwendungsdauer einer mit dieser integrierten Schaltung versehenen Karte niemals mehr durchgeführt. Das Abschalten kann beispielsweise dadurch erfolgen, daß eine Sicherung in der integrierten Schaltung durch einen Stromstoß durchgeschmolzen wird oder daß eine einzelne bestimmte Speicherzelle des EEPROM oder eine gesonderte Speicherzelle nach der Prüfung mit einer bestimmten Information beschrieben wird und dadurch einen späteren Prüfvorgang verhindert. Eine andere Möglichkeit besteht beispielsweise darin, eine Leiterbahn, die für die Aktivierung der Prüfschaltung notwendig ist, aus der integrierten Schaltung herauszuführen, so daß sie über einen Bereich auf der Halbleiterscheibe führt, über den der Trennschnitt bei der Trennung der gemeinsam hergestellten integrierten Schaltungen führt. Diese Möglichkeit hat den Vorteil, daß der Prüfschritt wiederholt werden kann, solange die integrierten Schaltungen auf der Halbleiterscheibe noch nicht voneinander getrennt sind.

Es kann bei der Herstellung von integrierten Schaltungen vorkommen, daß z.B. durch einen Fehler die Leiterbahnen der Versorgungsspannung innerhalb der integrierten Schaltung einen Kurzschluß aufweisen. Bei einer gleichzeitigen Speisung mehrerer integrierter Schaltungen könnte in dem Falle, daß eine dieser Schaltungen davon einen Spannungskurzschluß aufweist, der erste Prüfschritt auch für die anderen integrierten Schaltungen nicht durchgeführt werden. Nach einer Ausgestaltung der Erfindung ist es daher zweckmäßig, daß eine unmittelbar mit einem der Spannungsanschlüsse verbundene Strombegrenzungsschaltung vorgesehen ist und daß alle weiteren Elemente der integrierten Schaltung nur über die Strombegrenzungsschaltung mit dem einen Spannungsanschluß verbunden sind. In diesem Falle würde eine defekte integrierte Schaltung nur einen begrenzten Strom aus der Versorgungsspannung ableiten, so daß weitere, gleichzeitig geprüfte integrierte Schaltungen parallel von derselben Spannungsversorgung gespeist werden können.

Die Steuerung der Prüfschaltung bzw. der Ablaufsteuerung darin mittels Steuertakten kann auch ohne Verwendung eines zusätzlichen Anschlusses über die Versorgungsspannungsquelle erfolgen, insbesondere wenn für wenigstens einen Pol der Versorgungsspannung im ersten Prüfschritt ein gesonderter Anschluß verwendet wird. Dazu wird die Versorgungsspannung periodisch zwischen einem Spannungswert, der für den Betrieb der Steuerschaltung ausreichend ist, und einem höheren Spannungswert, der der Programmierspannung des EEPROM entspricht, umgeschaltet. Jedesmal wenn die Versorgungsspannung den Programmierspannungswert annimmt, werden alle Speicherzellen parallel mit einer Information beschrieben, deren Wert nach jeder Rückkehr der Versorgungsspannung auf den Normalwert umgeschaltet wird. Um zu vermeiden, daß in diesem Fall die Elemente der Steuerschaltung beim Umschalten auf den Programmierspannungswert zerstört werden, ist es nach einer weiteren Ausgestaltung der Erfindung zweckmäßig, daß eine mit einem der Spannungsanschlüsse gekoppelte Spannungsregelschaltung vorgesehen ist, um bei Eingangsspannungen innerhalb eines vorgegebenen Wertebereichs eine im wesentlichen konstante Ausgangsspannung zu erzeugen, die zum Speisen wenigstens eines Teils der Elemente der integrierten Schaltung dient. Dadurch läßt sich eine besonders einfache Steuerung des ersten Prüfschritts erreichen.

Die gleichzeitige Prüfung mehrerer integrierter Schaltungen bietet sich aus dem Grunde an, daß integrierte Schaltungen in großer Zahl auf einer einzigen Halbleiterscheibe hergestellt werden. Die erste Prüfung der integrierten Schaltung erfolgt dann nach dem letzten Herstellungsschritt noch auf der Halbleiterscheibe, bevor die integrierten Schaltungen voneinander getrennt werden. Die Erfindung bezieht sich daher auch auf eine eingangs genannte Halbleiterscheibe mit einer Mehrzahl von darauf erzeugten erfindungsgemäßen integrierten Schaltungen, wobei die zusätzliche Aufgabe besteht, die Prüfung der integrierten Schaltungen auf der Halbleiterscheibe besonders einfach durchzuführen. Diese Aufgabe wird erfindungsgemäß dadurch gelöst, daß wenigstens die Spannungsanschlüsse wenigstens einer Anzahl von benachbarten integrierten Schaltungen über Leiterbahnen, die über die Bahnen für die Trennschnitte auf der Halbleiterscheibe verlaufen, miteinander verbunden sind. Dadurch ist es besonders einfach, mehrere integrierte Schaltungen auf der Halbleiterscheibe gleichzeitig mit Spannung zu versorgen und dadurch den ersten Prüfschritt gleichzeitig für diese integrierten Schaltungen durchzuführen.

Die Erfindung bezieht sich ferner auf das eingangs genannte Verfahren zum Prüfen der Funktionsfähigkeit von erfindungsgemäßen integrierten Schaltungen auf der Halbleiterscheibe, das also in zwei Prüfschritten mit dazwischen liegender Wärmebehandlung durchgeführt wird. Um den ersten Prüfschritt möglichst schnell und mit einer möglichst einfachen Anordnung durchführen zu können, ist das erfindungsgemäße Verfahren dadurch gekennzeichnet, daß im ersten Prüfschritt nur die Leiterbahnen, über die die Spannungsanschlüsse wenigstens einer Anzahl von benachbarten integrierten Schaltungen miteinander verbunden sind, an eine Spannung angeschlossen werden, um das automatische abwechselnde Einschreiben der binären Information "0" und "1" an allen Speicherplätzen des EEPROM durch die Steuerschaltung auszulösen, und daß alle weiteren Schreib-Lese- und Löschprüfungen, vorzugsweise beginnend mit einer Leseprüfung, erst im zweiten Prüfschritt nach der Wärmebehandlung durchgeführt werden. Im ersten Prüfschritt werden also nur jeweils eine Anzahl integrierter Schaltungen mit Betriebsspannung und einfachen Steuersignalen versorgt, wodurch dann schließlich ein definierter Informationszustand im EEPROM jeder integrierten Schaltung eingestellt wird, ohne daß dieser Zustand geprüft wird. Es entfällt also ein Kontaktieren der übrigen Kontaktierungsflächen jeder integrierten Schaltung, und der erste Prüfschritt wird dadurch mit geringem Zeitaufwand durchgeführt. Fehlerhafte integrierte Schaltungen, bei denen beispielsweise schon das Einschreiben veränderter Daten in das EEPROM nicht möglich ist, werden dadurch erst beim zweiten Prüfschritt erkannt, was jedoch nicht nachteilig ist, da die Prüfung solcher defekten integrierten Schaltungen im ersten Prüfschritt keinerlei zusätzliche Zeit erfordert hat.

Ausführungsbeispiele der Erfindung werden nachstehend anhand der Zeichnung näher erläutert. Es zeigen:
Fig. 1 ein schematisches Blockschaltbild einer integrierten Schaltung,
Fig. 2 den Verlauf der Versorgungsspannung beim ersten Prüfschritt,
Fig. 3 die Anordnung mehrerer integrierter Schaltungen auf einer Halbleiterscheibe,
Fig. 4 eine andere Möglichkeit zum Verbinden der Spannungsversorgungsanschlüsse mehrerer integrierter Schaltungen auf der Halbleiterscheibe,
Fig. 5 ein Flußdiagramm zur Erläuterung der Durchführung der Prüfung.

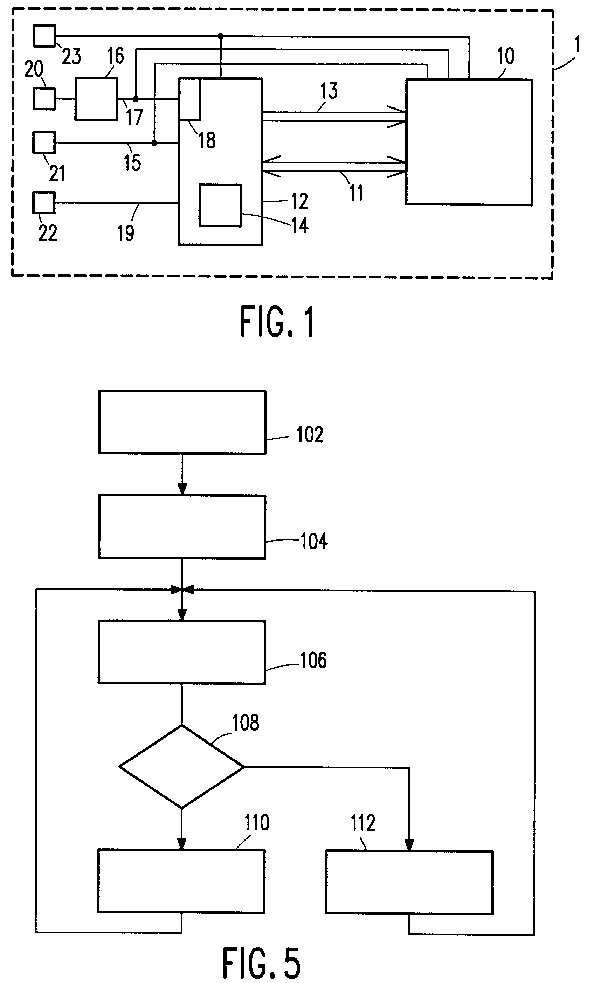

In Fig. 1 enthält eine einzelne integrierte Schaltung 1 einen EEPROM 10, der durch eine Steuerschaltung 12 über Adreßleitungen 13 und Datenleitungen 11 angesteuert wird. Der Aufbau der Steuerschaltung 12 kann in verschiedener Form erfolgen, wie allgemein bekannt ist. Der EEPROM 10 und die Steuerschaltung 12 werden hier über zwei Leitungen 15 und 17 mit Spannung versorgt, wobei die Leitung 15 direkt mit einem Spannungsanschluß 21 und die Leitung 17 über eine Strombegrenzungsschaltung 16 mit einem Spannungsanschluß 20 verbunden ist. Der Spannungsanschluß 20 wird hier nur für die Durchführung der Prüfung verwendet, im Normalbetrieb wird die Steuerschaltung 12 und der Speicher 10 über einen Spannungsanschluß 23 sowie den gemeinsamen Anschluß 21 mit Betriebsspannung versorgt. Die Leitung 17 führt am Eingang der Steuerschaltung 12 auf eine schematisch dargestellte Spannungsregelschaltung 18, die eine konstante Betriebsspannung für die Steuerschaltung 12 erzeugt und ein Steuertaktsignal für die Steuerung des Einschreibens abwechselnder Information aus Änderungen der Spannung auf der Leitung 17 abgeleitet. Die Steuerschaltung 12 ist ferner über eine Leitung 19 mit einem Signalanschluß 22 verbunden, jedoch ist klar, daß es auch eine größere Anzahl von Signalleitungen 19 mit entsprechend vielen Signalanschlüssen geben kann.

Die Steuerschaltung 12 enthält eine schematisch dargestellte Prüfschaltung 14, die beim Anlegen von Versorgungsspannung an die Anschlüsse 20 und 21 automatisch alle Adressen des EEEPROM 10 z.B. parallel ansteuert und an jeden adressierten Speicherplatz abwechselnd eine Anzahl Male die Information "1" bzw. "0" einschreibt. Zum Schluß wird die Information eingeschrieben, bei der das schwebende Gate, das jede Speicherzelle des EEPROM aufweist, aufgeladen ist.

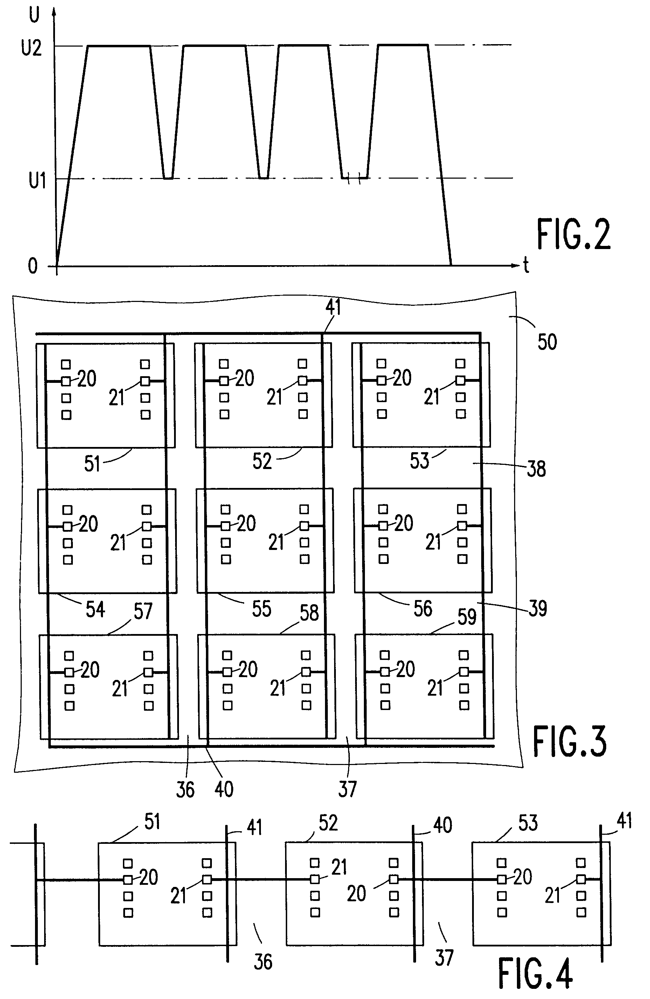

Die Steuerung für das abwechselnde Einschreiben der Information "1" und "0" erfolgt über die zugeführte Spannung, die den in Fig. 2 dargestellten Verlauf hat. Zunächst steigt die Spannung auf einen hohen Wert U2, wobei am Anfang die Steuerschaltung 12 in üblicher Weise auf einen definierten Anfangszustand gesetzt wird und nach Erreichen des Wertes U2, der der Programmierspannung des EEPROM 10 entspricht, eine durch diesen Anfangszustand definierte Information eingeschrieben wird. Dafür bleibt die Versorgungsspannung U eine genügend lange Zeit auf den Wert U2, und danach fällt sie auf den Wert U1, der etwa der normalen Betriebsspannung der Steuerschaltung 12 entspricht. Dabei wird die Information, die dem Speicher 10 anschließend zugeführt wird, auf den entgegengesetzten binären Wert gebracht. Danach steigt die Versorgungsspannung U wieder auf den Wert U2, womit diese eingestellte Information eingeschrieben wird. Dieser Wechsel der Versorgungsspannung U zwischen den beiden Werten U1 und U2 erfolgt mehrere Male, um die Speicherzellen einem Streß auszusetzen, über den Frühausfälle von Speicherzellen erkannt werden sollen. Eine Prüfung, ob die Informationen richtig eingeschrieben worden sind, d.h. eine Leseprüfung, erfolgt bei diesem Prüfschritt noch nicht, sondern erst in einem folgenden Prüfschritt, wie später erläutert wird.

Die Strombegrenzungsschaltung 16 ist in üblicher Weise aufgebaut, im einfachsten Fall als Vorwiderstand. Wenn aufgrund eines Defektes in der integrierten Schaltung 1 ein Kurzschluß zwischen den Leitungen 15 und 17 oder eine unzulässig niederohmige Verbindung in der Steuerschaltung oder dem EEPROM auftritt, wird von dem Spannungsanschluß 20 ein Strom abgeleitet, der nicht größer ist als der durch die Strombegrenzungsschaltung 16 vorgegebene Strom. Dadurch ist es auch bei defekten integrierten Schaltungen problemlos möglich, mehrere integrierte Schaltungen über dieselbe Versorgungsspannung parallel zu speisen.

Dies ist der Fall bei der in Fig. 3 dargestellten Anordnung, die einen Ausschnitt aus einer Halbleiterscheibe 50 zeigt, in der eine Vielzahl von integrierten Schaltungen enthalten ist, von denen hier beispielsweise nur eine Anzahl bzw. Gruppe von integrierten Schaltungen 51 bis 59 angedeutet sind. Diese integrierten Schaltungen sind ebenso wie die weiteren, nicht dargestellten Schaltungen regelmäßig in Reihen und Spalten angeordnet. Zwischen den Spalten von integrierten Schaltungen liegen Bahnen 36 und 37, und zwischen den Reihen von Schaltungen liegen Bahnen 38 und 39, durch die nach der Prüfung der integrierten Schaltungen Trennschnitte geführt werden, um die einzelnen integrierten Schaltungen voneinander zu trennen.

Jede integrierte Schaltung 51 bis 59 weist Kontaktierungsflächen auf, von denen hier nur die Spannungsanschlüsse 20 und 21 näher angedeutet sind, die denen in Fig. 1 entsprechen. Die Spannungsanschlüsse 20 aller integrierten Schaltungen der Gruppe sind mit einer Leiterbahn 40 verbunden, die in jeder Spalte die Bahnen 38 und 39 kreuzt und die am unteren Rand der integrierten Schaltungen 57 bis 59 neben der nicht näher bezeichneten Trennbahn verläuft und alle drei senkrechten Leiterbahnteile miteinander verbindet. In entsprechender Weise sind auch die Spannungsanschlüsse 21 aller integrierten Schaltungen der Gruppe mit einer Leiterbahn 41 verbunden, die ebenfalls die Bahnen 38 und 39 kreuzt und am oberen Rand der integrierten Schaltungen 51 bis 53 die senkrechten Leiterbahnteile miteinander verbindet.

Solange die Halbleiterscheibe 50 noch nicht zerteilt ist, genügt es, die Anschlüsse 20 und 21 von nur einer integrierten Schaltung aus jeder Gruppe zu kontaktieren und darüber Spannung zuzuführen. Damit werden alle integrierten Schaltungen dieser Gruppe mit Betriebsspannung versorgt. Wenn die zugeführte Spannung eine Kombination aus Versorgungsspannung und Steuersignalen ist, wie anhand der Fig. 2 erläutert wurde, wird im EEPROM aller integrierten Schaltungen gleichzeitig abwechselnd die Information "0" und "1" eingeschrieben. Dafür ist also nur die Kontaktierung von zwei Anschlüssen dieser Gruppe notwendig, und es wird auch nur eine einfache Prüfvorrichtung benötigt, die die Kombination aus Versorgungsspannung und Steuersignalen liefert.

Die Anzahl integrierter Schaltungen, die über jeweils ein Leiterpaar gemeinsam mit Betriebsspannung versorgt werden können, hängt im wesentlichen ab von der Stromaufnahme der einzelnen integrierten Schaltungen im normalen Betriebsfall sowie auch von der Breite der Leiterbahnen. Insbesondere bei geringer Stromaufnahme der einzelnen integrierten Schaltungen kann auch die in Fig. 4 angedeutete Anschlußmöglichkeit verwendet werden. Dabei ist also die integrierte Schaltung 51 um die vertikale Achse gespiegelt gegenüber der integrierten Schaltung 52 auf der Halbleiterscheibe angeordnet, so daß die Spannungsversorgungsanschlüsse einander zugewandt sind, und dies gilt auch für die übrigen integrierten Schaltungen in den einzelnen Spalten der Gruppe. Die Spannungsanschlüsse 20 und 21 von jeweils zwei Spalten von integrierten Schaltungen sind dann also mit derselben Leiterbahn 40 und 41 verbunden. Dadurch braucht dann zwischen Spalten von integrierten Schaltungen nur eine Leiterbahn 40 bzw. 41 vorgesehen zu werden.

Die Durchführung der Prüfung der integrierten Schaltungen auf der Halbleiterscheibe 50 erfolgt dann entsprechend dem in Fig. 5 dargestellten Flußdiagramm. Im Block 102 werden die Gruppen von integrierten Schaltungen nacheinander mit Spannung und (ggf. kombinierten) Steuersignalen versorgt, so daß in allen integrierten Schaltungen auf der Halbleiterscheibe, soweit die entsprechenden Elemente funktionsfähig sind, schließlich die gleiche Information enthalten ist. Gemäß dem Block 104 wird dann die Halbleiterscheibe während einer vorgegebenen Zeit auf eine vorgegebene hohe Temperatur gebracht.

Gemäß dem Block 106 wird nun eine einzelne integrierte Schaltung kontaktiert, jedoch nun die Spannungsanschlüsse 21 und 23 sowie der Signalanschluß 22 sowie ggf. weitere Signalanschlüsse in Fig. 1. Da nun die Steuerschaltung 12 nicht mehr über den Spannungsanschluß 20 versorgt wird, ist die Prüfschaltung 14 auch automatisch nicht in Betrieb, und die integrierte Schaltung kann über die Signalanschlüsse auf alle vorgesehene Funktionen überprüft werden. Insbesondere wird in der kontaktierten integrierten Schaltung zunächst der Inhalt des EEPROM Adresse für Adresse ausgelesen. Für jede Adresse wird gemäß dem Block 108 geprüft, ob die ausgelesene Information der vorgegebenen Information entspricht. Sobald dies nicht der Fall ist, wird die betreffende integrierte Schaltung gemäß dem Block 112 als defekt markiert, und die Prüfung geht auf den Block 106 für die nächste integrierte Schaltung über. Dadurch kann eine integrierte Schaltung, bei der die Ladungserhaltung und damit die Informationserhaltung über eine längere Zeit nicht arbeitet, äußerst schnell von der weiteren Prüfung ausgeschlossen werden, so daß die gesamte Prüfung beschleunigt wird.

Wenn die Prüfung gemäß Block 108 einer integrierten Schaltung zeigt, daß alle ausgelesenen Informationen richtig sind, werden im Block 110 die weiteren Prüfvorgänge durchgeführt, beispielsweise werden die einzelnen Speicherzellen des EEPROM gelöscht oder mit anderer Information überschrieben, wobei ebenfalls eine Überprüfung der geschriebenen Information folgt. Auch die Steuerschaltung selbst kann dabei in üblicher Weise überprüft werden. Nach der vollständigen Durchführung der Überprüfung für eine integrierte Schaltung wird immer wieder zum Block 106 zurückgegangen, gemäß dem die nächste integrierte Schaltung zunächst auf Ladungserhaltung und damit Informationserhaltung geprüft wird.

Durch dieses Verfahren kann bei der Prüfung einer Halbleiterscheibe mit einer großen Anzahl von integrierten Schaltungen, die einen EEPROM enthalten, die Zeit für den ersten Prüfschritt vor der Wärmebehandlung drastisch reduziert werden, wobei außerdem eine wesentlich einfachere Prüfeinrichtung verwendet werden kann.

## Patentansprüche

1. Integrierte Schaltung mit einem EEPROM sowie mit einer Steuerschaltung zum Steuern des Lesens und Schreibens von Information im EEPROM und mit Spannungsanschlüssen zum Zuführen einer Versorgungsspannung,
dadurch gekennzeichnet, daß die Steuerschaltung (12) eine Prüfschaltung (14) aufweist, die beim erstmaligen Zuführen von Spannung an wenigstens einige Spannungsanschlüsse (20, 21) weitgehend selbstttätig in alle Speicherzellen des EEPROM (10) vorzugsweise eine Anzahl Male abwechselnd die binäre Information "0" und "1" einschreibt.

2. Integrierte Schaltung nach Anspruch 1,
dadurch gekennzeichnet, daß die Prüfungschaltung (14) für die gesamte Lebensdauer der integrierten Schaltung dauerhaft abschaltbar ist.

3. Integrierte Schaltung nach Anspruch 1 oder 2,
dadurch gekennzeichnet, daß eine unmittelbar mit einem der Spannungsanschlüsse (20) verbundene Strombegrenzungsschaltung (16) vorgesehen ist und daß alle weiteren Elemente (10, 12, 14) der integrierten Schaltung (1) nur über die Strombegrenzungsschaltung (16) mit dem einen Spannungsanschluß (20) verbunden sind.

4. Integrierte Schaltung nach Anspruch 1, 2 oder 3,
dadurch gekennzeichnet, daß eine mit einem der Spannungsanschlüsse (20) gekoppelte Spannungsregelschaltung (18) vorgesehen ist, um bei Eingangsspannungen innerhalb eines vorgegebenen Wertebereichs eine im wesentlichen konstante Ausgangsspannung zu erzeugen, die zum Speisen wenigstens eines Teils der Elemente (10, 12, 14) der integrierten Schaltung (1) dient.

5. Halbleiterscheibe mit einer Mehrzahl von darauf erzeugten integrierten Schaltungen nach einem der Ansprüche 1 bis 4, die in Reihen und/oder Spalten mit dazwischen liegenden Bahnen für Trennschnitte zum Trennen der integrierten Schaltungen voneinander auf der Halbleiterscheibe angeordnet sind und von denen jede integrierte Schaltung Spannungsanschlüsse aufweist,
dadurch gekennzeichnet, daß wenigstens die Spannungsanschlüsse (20, 21) wenigstens einer Anzahl von benachbarten integrierten Schaltungen (51 bis 59) über Leiterbahnen (40, 41), die über die Bahnen (36 bis 39) für die Trennschnitte auf der Halbleiterscheibe (50) verlaufen, miteinander verbunden sind.

6. Verfahren zur Prüfung der Funktionsfähigkeit aller integrierten Schaltungen auf der Halbleiterscheibe nach Anspruch 5, wobei nach der vollständigen Herstellung die integrierten Schaltungen an eine Spannung angeschlossen werden zum Durchführen eines ersten Prüfschritts, nach dessen Abschluß alle Speicherplätze die gleiche vorgegebene Information enthalten, danach die Halbleiterscheibe im spannungslosen Zustand einer Wärmebehandlung unterzogen wird und anschließend die integrierten Schaltungen erneut an eine Spannung angeschlossen werden zum Durchführen eines zweiten Prüfschritts, in dem der Inhalt der Speicherplätze ausgelesen und geprüft wird,
dadurch gekennzeichnet, daß im ersten Prüfschritt nur die Leiterbahnen, über die die Spannungsanschlüsse wenigstens einer Anzahl von benachbarten integrierten Schaltungen miteinander verbunden sind, an eine Spannung angeschlossen werden, um das automatische abwechselnde Einschreiben der binären Information "0" und "1" an allen Speicherplätzen des EEPROM durch die Steuerschaltung auszulösen, und daß alle weiteren Schreib-Lese- und Löschprüfungen, vorzugsweise beginnend mit einer Leseprüfung, erst im zweiten Prüfschritt nach der Wärmebehandlung durchgeführt werden.
